# DEMANDE DE BREVET EUROPEEN

(11) **EP 2 512 028 A1**
(43) Date de publication de la demande: **17.10.2012**
(21) Numéro de dépôt: 11306446.3
(22) Date de dépôt: 08.11.2011
(51) Int. Cl.: H03B 28/00, G01S 13/32, G01S 7/35

(54) **Dispositif d'émission/réception d'ondes radar**

(30) Priorité: 12.11.2010 FR 1059319
(71) Demandeur: STMICROELECTRONICS SA, 92120 Montrouge (FR)
(72) Inventeur: Moquillon, Laurence, 38660 Lumbin (FR); Garcia, Patrice, 38920 Crolles (FR)
(74) Mandataire: Palix, Stéphane

(57) **Abrégé**

Dispositif (1) d'émission/réception d'ondes radar, en particulier de radars à modulation de fréquence:
■ un circuit (2) de génération d'ondes radar, comportant un oscillateur commandé en tension (6) couplé à un circulateur (8) lui-même relié à une antenne d'émission/réception (9) ;
■ un circuit de détection (3) comportant un premier mélangeur (15) alimenté par ledit circulateur (8) et ledit oscillateur commandé en tension (6),
et dans lequel l'oscillateur commandé en tension (6) comporte une entrée d'injection (56) d'un signal élaboré par un circuit complémentaire (30), ledit circuit complémentaire (30) étant alimenté en entrée par le signal de sortie (10) de l'oscillateur commandé en tension (6), et comportant un second mélangeur (36) alimenté par deux signaux (33,38) élaborés à partir du signal de sortie (10) de l'oscillateur commandé en tension (6).

## Description

### Domaine de l'invention

La présente invention concerne un dispositif d'émission d'ondes radar à modulation de fréquence, et en particulier des systèmes à ondes continues à fréquence modulée, également connus sous l'appellation « radars FMCW » pour « Frequency Modulated Continuous Wave ».

Elle vise plus particulièrement des agencements permettant de réduire le bruit basse fréquence présent dans le signal reçu, imputable à des phénomènes de fuite et de réflexion.

### Arrière plan de l'invention

De façon classique, un dispositif d'émission/réception d'ondes radars combine un circuit de génération et d'émission, avec un circuit de détection des ondes radars réfléchies sur les obstacles détectés.

Plus précisément, un circuit de génération d'ondes radar monostatique comporte classiquement un oscillateur commandé en tension, ou VCO pour « Voltage Controlled Oscillator » qui est couplé à un circulateur qui est lui-même relié à l'antenne d'émission/réception. La commande appropriée du VCO permet de générer les formes d'ondes souhaitées dans la gamme de fréquence voulue.

Après émission par l'antenne, les ondes réfléchies sur les éventuels obstacles peuvent également être détectées par cette même antenne. Ces ondes réfléchies présentent des caractéristiques de fréquence qui dépendent à la fois de la distance et de la vitesse relative des obstacles.

Le circuit de détection permettant l'élaboration du signal utile comprend un circulateur qui est relié à l'antenne, et qui délivre ainsi le signal reçu à un mélangeur dont une autre entrée est reliée au VCO.

Ce mélangeur délivre ainsi un signal en basse fréquence, qui peut ensuite être analysé par un module de traitement afin d'évaluer la distance et la vitesse de la cible.

De façon générale, on constate que des phénomènes de fuite peuvent apparaître, signifiant qu'une partie de la puissance générée en sortie du circuit d'émission n'est pas effectivement émise. Il peut s'agir, par exemple, de réflexions dues au pare-choc qui protège mécaniquement l'antenne, ou de situations dans lesquelles l'antenne présente des imperfections, ou est recouverte de matériaux réfléchissants les ondes radar. Dans ce cas, une partie de la puissance à émettre se retrouve directement dans le circuit de réception avec un niveau qui peut être relativement élevé.

En particulier, le bruit présent dans le signal émis peut se retrouver à un niveau important dans le signal de sortie du circuit de détection, puisque ce signal émis est recombiné avec le signal issu du VCO, qui possède un spectre fréquentiel quasi identique. On conçoit donc que la présence de fuites révèle le bruit présent dans le signal émis.

Différentes solutions ont d'ores et déjà été proposées pour réduire l'influence du bruit présent dans le signal émis.

Ainsi, une première solution consiste à insérer un déphaseur dans le circuit d'émission, en aval du VCO. On constate qu'en faisant varier le déphasage introduit, il est possible de minimiser l'influence du bruit dans le signal émis sur le signal de sortie. Toutefois, une telle solution reste très sélective, et n'a pas le même effet sur l'ensemble du spectre fréquentiel. Par ailleurs et surtout, la détermination du déphasage optimal peut s'avérer délicate voire impossible, dans la mesure où ce déphasage peut dépendre de multiples paramètres liés au dispositif et/ou à l'environnement extérieur.

Une autre solution a été proposée dans le document « Ka-Band FMCW Radar Front-End With Adaptative Leakage Cancellation » (IEEE transactions on microwave theory and techniques, vol. 54, n° 12, December 2006, page 4041*).* Cette solution permet de diminuer voire d'annuler l'influence du bruit du signal émis en soustrayant un filtrage du signal émis au signal de réception. Ce système reste toutefois très complexe à mettre en oeuvre et présente le désavantage de rendre le système insensible à des signaux dont la fréquence est trop proche de la porteuse du signal émis. De plus, il ne permet pas d'annuler la fuite dans la bande utile.

### Résumé de l'invention

On conçoit qu'il serait souhaitable de limiter l'influence des fuites, en fournissant un système qui soit simple à mettre en oeuvre. Il serait également utile qu'un tel système soit relativement insensible à la structure des éléments constitutifs du radar, tels qu'en particulier l'antenne, ainsi qu'aux facteurs extérieurs, comme la température en particulier.

Ainsi, pour atteindre tout ou partie de ces buts, selon un mode de réalisation de l'invention, le dispositif d'émission/réception d'ondes radar à modulation de fréquence peut inclure :
■ un circuit de générations d'ondes radar, qui comporte un oscillateur commandé en tension comportant une entrée permettant de contrôler sa fréquence de fonctionnement, cet oscillateur étant couplé à un circulateur lui-même relié à une antenne d'émission/réception ;
■ un circuit de détection comportant un premier mélangeur alimenté par ledit circuit circulateur et ledit oscillateur commandé en tension.

Dans ce mode de réalisation, l'oscillateur commandé en tension comporte une entrée complémentaire d'injection d'un signal élaboré par un circuit complémentaire. Ce circuit complémentaire est alimenté en entrée par le signal de sortie de l'oscillateur commandé en tension, et comporte un second mélangeur alimenté par un premier signal et un second signal élaborés à partir du signal de sortie de l'oscillateur commandé en tension.

Dans une variante de réalisation, le circuit d'émission peut inclure un amplificateur connecté entre l'oscillateur commandé en tension et le circulateur, de manière à obtenir le niveau de puissance souhaité. Selon ce niveau de puissance, l'influence des fuites peut être plus ou moins sensible, et l'intérêt du circuit complémentaire peut être d'autant plus important.

Dans une variante d'architecture, le circuit de détection peut inclure un amplificateur à faible bruit connecté entre le circulateur et le premier mélangeur. Il est également possible que l'amplification correspondante soit réalisée au sein même du mélangeur.

Dans un mode de réalisation particulier, les deux signaux alimentant le second mélangeur du circuit complémentaire correspondent au signal de sortie de l'oscillateur commandé en tension.

Dans un autre mode de réalisation, le circuit complémentaire peut comporter un étage déphaseur agissant sur le second signal alimentant le second mélangeur, de sorte que ce dernier agit sur deux signaux déphasés.

Dans un mode de réalisation particulier, cet angle de déphasage peut être réglable.

Dans un mode d'exécution particulier, le circuit complémentaire peut comporter un étage de filtrage passe-bas situé en sortie du second mélangeur, de façon à réinjecter dans le VCO un signal représentatif du bruit d'amplitude basse fréquence.

### Description sommaire des dessins

Certaines caractéristiques de l'invention, ainsi que les avantages qui en découlent, ressortiront bien de la description des modes de réalisation qui suivent, à l'appui des figures annexées données à titre d'exemples non limitatifs, et dans lesquelles :
- la figure 1 est un schéma électrique simplifié montrant les différents éléments constituant un dispositif d'émission/réception d'ondes radar selon un mode de réalisation particulier;
- la figure 2 est un schéma électrique simplifié montrant un oscillateur contrôlé en tension, pouvant être intégré dans le schéma de la figure 1.
- la figure 3 est un schéma électrique simplifié montrant une variante de réalisation d'un oscillateur contrôlé en tension, pouvant être intégré dans le schéma de la figure 1.

### Description détaillée

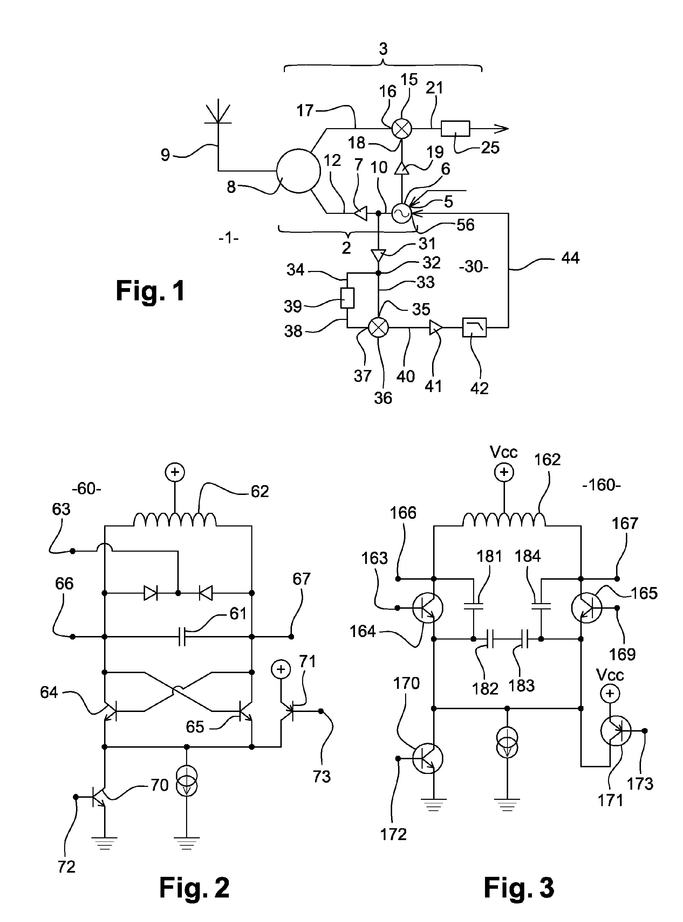

Tel qu'illustré à la figure 1, le dispositif **1** d'émission/réception d'ondes radar comporte un circuit d'émission **2** et un circuit de réception **3.** Le circuit **2** comprend principalement un oscillateur **6** contrôlé en tension (ou VCO), un amplificateur de puissance **7** et un circulateur **8.** Le VCO **6** peut être de conceptions très variées, dès lors qu'il permet de générer un signal **10** à fréquence variable. Plus précisément, pour l'application des radars FMCW, la fréquence du signal de sortie du VCO varie linéairement dans le temps entre deux bornes de fréquences données. De même, dans la forme illustrée, le VCO **6** comporte une entrée **5** qui permet de faire varier sa fréquence de fonctionnement. Cette entrée **5** peut être réalisée de diverses manières, et par exemple être unique ou différentielle selon la structure du VCO.

Ce signal de sortie **10** alimente un amplificateur de puissance **7** de conception traditionnelle. Cet amplificateur de puissance **7** délivre un signal **12** à un circulateur **8** lié à l'antenne d'émission/réception **9** selon un mode classique. De même, le circulateur **8** fait partie du circuit de réception **3,** qui comporte un mélangeur **15.** Ce mélangeur **15** possède donc une première entrée **16** qui correspond au signal **17** reçu par l'antenne. Le mélangeur **15** peut inclure une fonction d'amplification, mais il est également possible que l'amplification, si nécessaire, soit réalisée par un composant spécifique, préférentiellement à faible bruit, connecté entre le circulateur **8** et le mélangeur **15.** L'autre entrée **18** du mélangeur **15** est reliée au VCO **6** par l'intermédiaire d'un amplificateur de puissance **19.** De la même manière, cette amplification peut être réalisée par un étage du mélangeur **15.** Ce mélangeur **15** assure donc la multiplication des deux signaux reliés à ces deux entrées **16,18,** de sorte que le signal **21** généré par le mélangeur **15** présente, dans la partie basse de son spectre fréquentiel, des composantes dans une bande de fréquence correspondante à la différence entre la fréquence du signal du VCO **6,** c'est-à-dire la fréquence du signal émis, et la fréquence du signal reçu **17.** Cette différence de fréquence est directement liée à la distance, à la vitesse de la cible ayant réfléchi les ondes émises ainsi qu'à la vitesse de modulation. Il s'agit donc du signal utile qui peut ensuite être analysé par un module **25** de traitement du signal approprié, qu'il n'est pas nécessaire de décrire ici en détail.

Tel qu'illustré à la figure 1, le dispositif 1 comporte également un circuit complémentaire **30** destiné à réduire le bruit d'amplitude généré par le VCO **6.** Plus précisément, dans le mode de réalisation illustré à la figure 1, le circuit complémentaire comporte un amplificateur **31** jouant en particulier un rôle d'adaptateur d'impédance. Ceci permet de générer un signal **32** correspondant au signal de sortie **10** du VCO **6,** qui peut être dupliqué pour former deux voies **33,34.** L'un de ces signaux **33** alimente une première entrée **35** du second mélangeur **36.** L'autre entrée **37** du mélangeur **36** est alimentée par un second signal **38** qui, dans la forme illustrée, est élaboré à partir du signal de sortie **10** du VCO **6** par l'application d'un déphasage donné par un étage déphaseur **39.** Le réglage du déphasage généré par le déphaseur **39** permet de minimiser la tension continue d'offset qui peut perturber le bon fonctionnement de l'amplificateur **41.** Toutefois, de bons résultats sont obtenus sur la réduction du bruit du VCO en l'absence de ce déphaseur, ou avec d'autres moyens permettant de réduire voire d'annuler cette tension continue d'offset.

Le signal de sortie **40** du mélangeur **36** présente une composante à basse fréquence, qui est directement liée au bruit d'amplitude du VCO **6.** Ce signal **40** alimente un amplificateur **41** et un filtre passe-bas **42,** dont la fréquence de coupure est déterminée en fonction du spectre de bruit d'amplitude que l'on souhaite éliminer, et qui est typiquement de l'ordre de quelques dizaines à quelques centaines de Hertz.

Ce signal **44** ainsi filtré est ensuite injecté dans le VCO **6** par une entrée complémentaire **56** de telle manière à former une boucle de rétroaction pour le signal du bruit d'amplitude généré par le VCO. Le signal **44** est dephasé de 180° pour se soustraire au bruit interne au VCO. Ce déphasage peut être obtenu par tout circuit approprié, ou encore par une inversion des connexions entre la sortie du filtre passe-bas **42** ou le mélangeur **36** et le VCO **6,** lorsque les montages se font en différentiel.

Le gain **G_{B}** de cette boucle de rétroaction se compose du gain **G₁** de l'amplificateur **31,** du gain **G₂** du mélangeur **36** pris entre la fréquence fondamentale du VCO et la basse fréquence, et du gain **G₃** de l'amplificateur **41** combiné au filtre passe-bas **42.** Le gain **G_{A}**, correspondant au rapport entre le bruit d'amplitude généré par le VCO rapporté au signal caractéristique injecté **44,** présente une valeur qui dépend de la conception du VCO, des composants qui l'intègrent et d'autres facteurs extérieurs. Afin d'obtenir un bruit d'amplitude qui soit le plus faible possible, il convient que le gain en boucle ouverte qui est le produit du gain **G_{A}** par le gain **G_{B}** de la boucle de rétroaction soit très supérieur ou très inférieur à 1. Ainsi, un choix du gain **G_{B}** de la boucle de rétroaction très élevée permet de s'affranchir de la détermination qui pèse sur le gain **G_{A}** en boucle ouverte.

Bien entendu, en pratique, le mélangeur **36,** les différents étages amplificateurs **31,41** et le filtre passe-bas **42,** peuvent être réalisés par des composants distincts, ou encore des composants réalisant plusieurs de ces formes, voire même un seul et unique composant global.

D'un point de vue pratique, le VCO **6** est conçu de manière à présenter une entrée **56** qui permette de réinjecter un signal en vue d'annuler son bruit d'amplitude. Différentes possibilités sont ouvertes, en fonction du type de schéma de VCO choisi.

Un exemple particulier est illustré à la figure 2, qui correspond à un VCO de type « *oscillateur à structure LC couplée* ». Un tel VCO **60** comporte, de façon classique, un circuit résonant incluant une capacité **61** et une inductance **62** formant un circuit résonant, et une entrée de commande **63** permettant de modifier la fréquence d'oscillation, ainsi que deux transistors **64,65** fonctionnant en commutation. Les bornes **66, 67** délivrent de manière différentielle le signal de sortie du VCO, à la fréquence souhaitée.

Dans la forme illustrée à la figure 2, le VCO **60** comporte également une entrée différentielle complémentaire formée par les deux transistors complémentaires **70,71** par les bases **72,73** desquelles est appliqué le signal issu de la boucle de rétroaction. Ces deux transistors **70,71** sont conçus pour recevoir avantageusement un signal sous forme différentielle, mais il est également possible, par des adaptations à la portée de l'homme du métier, de prévoir une seule entrée d'injection du signal de rétroaction.

Bien entendu, d'autres structures de VCO peuvent être envisagées, comme par exemple celui illustré à la figure 3, présentant une structure Colpitts. Un tel VCO **160** comporte, de façon classique, un circuit résonant incluant un ensemble de capacités **181,182,183,184** et une inductance **162,** et deux entrées de commande **163,169** constituées des bases de deux transistors **164,165,** permettant de modifier la fréquence d'oscillation. Les bornes **166, 167** délivrent de manière différentielle le signal de sortie du VCO, à la fréquence souhaitée.

Dans la forme illustrée à la figure 3, le VCO **160** comporte également une entrée complémentaire différentielle formée par les deux transistors complémentaires **170,171** par les bases **172,173** desquelles est appliqué le signal issu de la boucle de rétroaction. Ces deux transistors **170,171** sont prévus pour recevoir un signal sous forme différentielle, mais il est également possible, par des adaptations à la portée de l'homme du métier, de prévoir une seule entrée d'injection du signal de rétroaction.

De façon générale, l'injection du signal de rétroaction se fait à un endroit du circuit du VCO qui rend le système insensible pour la conversion vers le bruit de la porteuse.

Ainsi, la Demanderesse a réalisé des essais qui lui ont permis de détecter que, contrairement à une idée reçue, les oscillateurs contrôlés en tension peuvent être une source de bruit d'amplitude non négligeable. Ainsi, en agissant directement sur le VCO pour compenser le niveau de bruit dans le signal généré par ce dernier, la Demanderesse a obtenu des résultats satisfaisants sur le niveau du signal parasite que l'on observe lorsque les fuites apparaissent dans le circuit d'émission 2. L'utilisation du circuit complémentaire **30** de réduction du bruit du VCO présente l'avantage de permettre une réduction du bruit sans utiliser le signal utile, c'est-à-dire le signal transmis à l'antenne.

Bien entendu, d'autres variantes peuvent être réalisées dans le même esprit, en tenant compte pour la détermination de chacun des éléments, de contraintes imposées par d'autres systèmes interagissant avec le dispositif d'émission/réception, et en particulier une boucle de verrouillage de phase (PLL). Ainsi, l'homme du métier s'assurera classiquement de la stabilité de toutes les boucles de régulation imbriquant ou interagissant avec la boucle de régulation du bruit d'amplitude du VCO décrite ci-avant.

## Revendications

1. Dispositif (1) d'émission/réception d'ondes radar, de type à modulation de fréquence, incluant :
■ un circuit (2) de génération d'ondes radar, comportant un oscillateur commandé en tension (6) comportant une entrée (5) permettant le contrôle de sa fréquence de fonctionnement, ledit oscillateur (6) étant couplé à un circulateur (8) lui-même couplé à une antenne d'émission/réception (9) ;
■ un circuit de détection (3) comportant un premier mélangeur (15) adapté à être alimenté par ledit circulateur (8) et ledit oscillateur commandé en tension (6),
et dans lequel l'oscillateur commandé en tension (6) comporte une entrée complémentaire d'injection (56) d'un signal élaboré par un circuit complémentaire (30), ledit circuit complémentaire (30) étant adapté à être alimenté en entrée par le signal de sortie (10) de l'oscillateur commandé en tension (6), et comportant un deuxième mélangeur (36) adapté à être alimenté par un premier signal (33) et un second signaux (38) élaborés à partir du signal de sortie (10) de l'oscillateur commandé en tension (6).

2. Dispositif selon la revendication 1 dans lequel un amplificateur de puissance est connecté entre l'oscillateur commandé en tension (6) et le circulateur (8).

3. Dispositif selon la revendication 1 ou 2 dans lequel un amplificateur à faible bruit est connecté entre le circulateur (8) et le premier mélangeur (15).

4. Dispositif selon l'une quelconque des revendications 1 à 3 dans lequel le premier signal (33) alimentant le deuxième mélangeur (36) correspond au signal de sortie de l'oscillateur commandé en tension (10).

5. Dispositif selon l'une quelconque des revendications 1 à 4 dans lequel le deuxième signal (38) alimentant le deuxième mélangeur (36) correspond au signal de sortie de l'oscillateur commandé en tension (10).

6. Dispositif selon l'une quelconque des revendications 1 à 5 dans lequel le circuit complémentaire (30) comporte un étage déphaseur (39) adapté à agir sur le deuxième signal (38) alimentant le deuxième mélangeur (36).

7. Dispositif selon la revendication 6 dans lequel l'angle de déphasage de l'étage déphaseur (39) est réglable.

8. Dispositif selon l'une quelconque des revendications 1 à 7, dans lequel le circuit complémentaire (30) comporte un étage de filtrage (42) passe-bas en sortie du deuxième mélangeur (36).
